# EUROPEAN PATENT SPECIFICATION

(11) **EP 0 981 655 B1**
(45) Date of publication and mention of the grant of the patent: **16.10.2002**
(21) Application number: 98921599.1
(22) Date of filing: 13.05.1998
(51) Int. Cl.: C23C 16/00

(54) **CHEMICAL VAPOUR DEPOSITION PRECURSORS**
VORPRODUKT FÜR CVD
PRECURSEURS UTILISES DANS LES TECHNIQUES DE DEPOT CHIMIQUE EN PHASE VAPEUR

(30) Priority: 14.05.1997 GB 9709639; 29.11.1997 GB 9725220
(43) Date of publication of application: 01.03.2000
(73) Proprietor: QinetiQ Limited, London, SW1 6TD (GB)
(72) Inventor: JONES, Anthony, Copeland, Rosetree Cottage, Prescot L35 7JW (GB); LEEDHAM, Timothy, John, Milden Hall, Suffolk, IP 28 7DE (GB); CROSBIE, Michael, John, Pershore, Worcestershire WR10 1NW (GB); WILLIAMS, Dennis, John, Malvern Link, Worcestershire WR14 1LD (GB); WRIGHT, Peter, John, Malvern, Worcestershire WR14 3JY (GB); LANE, Penelope, Anne, Malvern, Worcestershire WR14 3JY (GB)
(86) International application number: GB9801365
(87) International publication number: WO98051837

(56) References cited:
- WO-A1-93/18202
- WO-A1-96/40690

## Description

This invention concerns precursors for use in chemical vapour deposition techniques, the production of electro-ceramic devices therefrom, and their use in ferro-electric memories and I.R. detectors.

Metalorganic chemical vapour deposition (MOCVD) is a preferred method for depositing thin films, i.e. in the order of a few µm of ferroelectric metal oxides, such as lead zirconate titanate, [Pb(Zr,Ti)O₃ or PZT and lanthanum-modified lead zirconate titanate, [(Pb,La)(Zr,Ti)O₃ or PLZT]. These electro-ceramic materials have a wide range of useful dielectric, ferroelectric, piezoelectric, pyroelectric and electrostrictive properties, giving rise to a variety of potential applications ranging from thermal imaging and security systems to integrated optics and computer memories, e.g. DRAMS and non-volatile FERAMS.

The MOCVD technique involves transporting a metal as a volatile metalorganic compound in the vapour phase followed by thermal decomposition usually in the presence of oxygen on an appropriate substrate. The different types of substrate can be divided into three groups, namely oxides, semiconductors and metals. Examples of suitable oxide substrates are SiO₂, SrTiO₃, MgO and Al₂O₃. Semiconductor substrates include silicon (Si) and germanium (Ge) and metal substrates may be, for example, molybdenum (Mo) or tungsten (W). MOCVD has a number of advantages over other deposition techniques, such as sol-gel or physical vapour deposition. MOCVD offers potential for large-area deposition, excellent film uniformity and composition control, high film densities and deposition rates and excellent conformal step coverage at dimensions less than 2µm. Furthermore, MOCVD processes are compatible with existing silicon chemical vapour deposition processes used in ULSI and VLSI applications.

Precursors for MOCVD of electro-ceramic thin films are generally metal β-diketonates, such as, for example, lead bis-tetramethylheptanedionate (Pb(thd)₂, or metal alkoxides. WO 96/40690 discloses various metalorganic complexes of the formula MAyX, wherein M is a y-valent metal, A is a monodentrate or multidentrate organic ligand coordinated to M which allows complexing of MAy with X, y is a integer having a value of 2,3 or 4 and X is a monodentrate, or multidentrate ligand coordinated to M and containing one or more atoms independently selected from C, N, H, S, O and F. A may be a β-diketonate and X may be tetraglyme, tetrahyrofuran, bipyridine, crown ether or thioether.

It is important that the precursors are volatile enough to be transported efficiently at source temperatures which are below the precursor decomposition temperature. In other words, there should be an adequate temperature window between vaporisation and decomposition. The precursors used need to be compatible and not pre-react. They should decompose to form the desired metal oxide in the same temperature region. Ideally, precursors have low toxicity and are stable under ambient conditions.

Available metal alkoxide and metal β-diketonate precursors generally have only very low vapour pressures, so that high source temperatures are required for MOCVD. For example, Pb(thd)₂ is typically transported at above 130°C and Zr(thd)₄ at above 160°C. In conventional MOCVD in which a carrier gas is passed through a precursor held at a high temperature for the duration of the deposition process, this can lead to thermal ageing, i.e. decomposition of the precursor prior to transport into the reactor.

One way of avoiding this problem has been to use liquid injection MOCVD, in which a solution of the precursor(s) in an appropriate solvent, e.g. tetrahydrofuran, is evaporated and then transported to the substrate. In this way the precursor is only subjected to heating during evaporation rather than for the duration of the MOCVD process.

For ease of handling and volatility, toxicity and decomposition characteristics, the optimum precursor combination for MOCVD of PZT is Pb(thd)₂, Zr(thd)₄ and either Ti(OPrⁱ)₄ or Ti(OPrⁱ)₂(thd)₂. However, there is a problem with using Zr(thd)₄, in that it is too stable, making it difficult to control the stoichiometry of PZT during liquid delivery MOCVD. In particular, there is a large difference between the decomposition temperature of Zr(thd)₄ and the most useful lead precursor Pb(thd)₂. This results in a significant difference between the temperatures for diffusion (or mass-limited) oxide film growth between the two precursors and the need to use high substrate temperatures to decompose the Zr(thd)₄ source leads to a loss of lead from the PZT films by evaporation.

Zirconium alkoxides, such as Zr(OPrⁱ)₄ and Zr(OBu^{t})₄ are predicted to be much less thermally stable than Zr(thd)₄ but are highly air and moisture sensitive making them difficult to manufacture in pure form and too unstable for long term storage.

An object of this invention is to provide alternative Zr precursors for use in MOCVD, especially for depositing PZT and PZLT.

Another object of the invention is to provide an improved method of depositing zirconium containing metal oxides in thin films.

According to a first aspect of this invention there is provided a zirconium precursor suitable for use in MOCVD having the formula

Zrₓ(OR)_{y}L_{z}

wherein
R is an alkyl group
L is a β-diketonate group.
x = 1 or 2
y = 2, 4 or 6, and
z = 1 or 2

According to a second aspect of the invention there is provided a method of depositing thin films of or containing zirconium oxide using metalorganic precursors in an MOCVD technique, wherein the zirconium precursor has the formula

Zrₓ(OR)_{y}L_{z}

wherein
R is an alkyl group
L is a β -diketonate group.
x = 1 or 2
y = 2, 4 or 6, and
z = 1 or 2

The preferred alkyl groups R are branched chain alkyl groups, preferably having less than 10 carbon atoms, more preferably having 1 to 6 carbon atoms, especially iso-propyl and tertiary-butyl groups.

The preferred β-diketonate groups L include those of the general formula 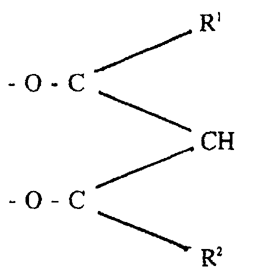 wherein R¹ and R² are the same or different and are straight or branched, optionally substituted, alkyl groups or, optionally substituted, phenyl groups. Examples of suitable substituents include chlorine, fluorine and methoxy.

Examples of suitable β-diketonate groups for use in precursors of the invention include the following:

| R¹ | R² | |
|---|---|---|
| CH₃ | CH₃ | acetylacetonate (acac) |
| CF₃ | CH₃ | trifluoroacetylacetonate (tfac) |
| CF₃ | CF₃ | hexafluoroacetylacetonate (hfac) |
| CH₃ | C(CH)₃ | dimethylheptanedionate (dhd) |
| C(CH)₃ | C(CH)₃ | tetramethylheptanedionate (thd) |
| CH₃ | CF₂CF₂CF₃ | heptafluoroheptanedionate (fhd) |
| C(CH)₃ | CF₂CF₂CF₃ | heptafluorodimethyloctanedionate (fod) |
| CF₂CF₂CF₃ | CF₂CF₂CF₃ | tetradecafluorononanedionate (tdfnd) |
| C(CH₃)₃ | CF₃ | trifluorodimethylhexanedionate (tpm) |
| CF₃ | CF₂CF₃ | octafluorohexanedionate (ofhd) |
| C(CH₃)₃ | CF₂CF₃ | pentafluorodimethylheptanedionate (ppm) |
| CF₃ | CF₂CF₂CF₃ | decafluoroheptanedionate (dfhd) |
| C(CH₃)₃ | CH₂CH₂CH₂OCH₃ | dimethylmethoxyoctanedionate (dmmod) |
| CCL₃ | CH₃ | trichloropentanedionate (tclac) |
| Ph | Ph | diphenylpropanedionate (dpp) |

In one preferred embodiment of the invention the zirconium precursor has the following formula:

Zr(OR)₂L₂

wherein R and L are as defined above.

Typical examples of such zirconium precursors include Zr(OPrⁱ)₂ (thd)₂ and Zr(OBu^{t})₂(thd)₂

These compounds are believed to be particularly suitable for use in the method according to the invention, especially in liquid injection MOCVD.

In another preferred embodiment of the invention, the zirconium precursor has the following formula:

Zr₂(OPrⁱ)₆(thd)₂

Again this compound is believed to be particularly suitable for use in the method of the invention, especially in liquid injection MOCVD.

Compounds of the invention may be produced by reaction of an appropriate zirconium alkoxide with an appropriate β-diketone.

The method of the invention is particularly useful for depositing on a substrate thin films, i.e. in the order of up to 5µm of lead zirconate titanate (PZT) using a zirconium precursor according to the invention with a lead precursor, such as Pb(thd)₂ or lanthanum-modified lead zirconate titanate (PLZT). Typical substrates include SiO₂, Si, SrTiO₃, MgO, Al₂O₃, Ge, Mo and W.

According to a further aspect of the present invention there is provided a method of forming an electro-ceramic device comprising the steps of depositing a lower conducting electrode onto a substrate, depositing a film layer of or containing zirconium oxide onto said electrode and depositing an upper or further conducting electrode thereon, wherein the zirconium oxide layer is formed from the zirconium precursor having the formula:-

Zrx(OR)yLz

wherein
R is an alkyl group;
L is a β-diketonate group;
x = 1 or 2;
y = 2, 4 or 6; and
z = 1 or 2.

The lower conducting electrode and upper conducting electrode is preferably a metal, for example, platinum. The substrate is preferably a silicon wafer or circuit. An electro-ceramic device formed by this method is particularly suitable for use in ferro-electric memories and infra-red detectors.

This invention will be further described with reference to the accompanying drawings, in which:
Figure 1 shows ¹H NMR spectrum for the product prepared in Example 1 below;
Figure 2 shows mass spectrometry results for the product prepared in Example 1 below;
Figure 3 shows ¹H NMR spectrum for the product prepared in Example 2 below;
Figure 4 shows mass spectrometry results for the product prepared in Example 2 below;
Figure 5 is a plot of growth rates against substrate temperature achieved by MOCVD using the products of Examples 1 and 2;
Figure 6 shows a plot of growth rates against substrate temperature achieved by MOCVD using a lead precursor;
Figure 7 shows the likely chemical structure of Zr₂(OPrⁱ)₆(thd)₂;
Figure 8 is a plot of the growth rates against substrate temperature achieved using the precursor Zr₂(OPrⁱ)₆(thd)₂; and
Figure 9 is a lateral cross-sectional view of an electro-ceramic device according to one embodiment of the present invention.

This invention will now he further described by means of the following Examples.

### Example 1

### Preparation of zirconium di-isopropoxy bis-tetramethylheptanedionate.

74g of tetramethylheptanedionate were dissolved with stirring in 1 litre of hexane in a 2 litre flask.

75g of zirconium isopropoxide iso-propanol adduct were added to the flask and the mixture brought to reflux for 1 hour. The flask was cooled and the contents filtered through a pad and reduced in volume to dampness using a Buchi roto-evaporator. The residue was redissolved in 300ml of hexane, clarified through a filter pad, stripped to half volume and 300ml of dry isopropanol were added. The resultant solution was reduced in volume to 150ml and set aside to crystallize then filtered off. The crystals were air dried or gently Buchi dried until the odour of isopropanol was removed.

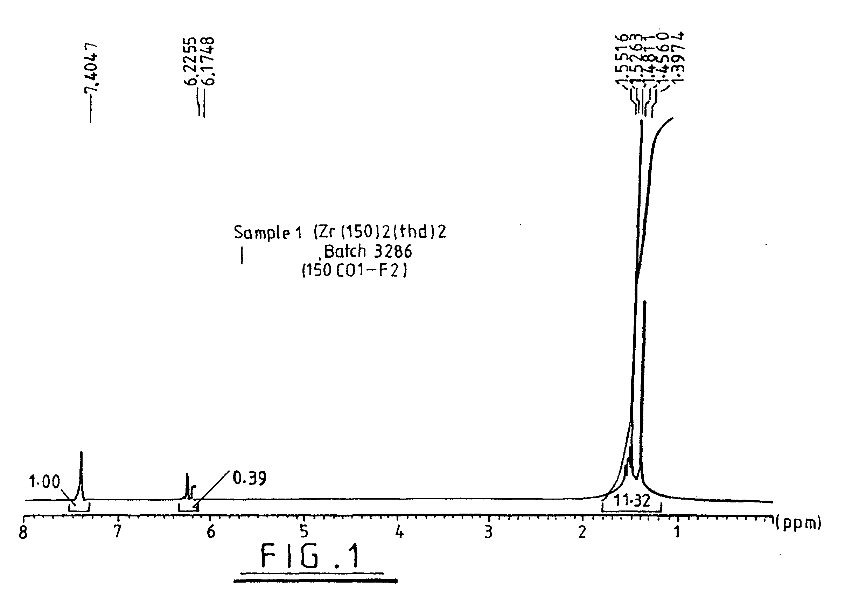

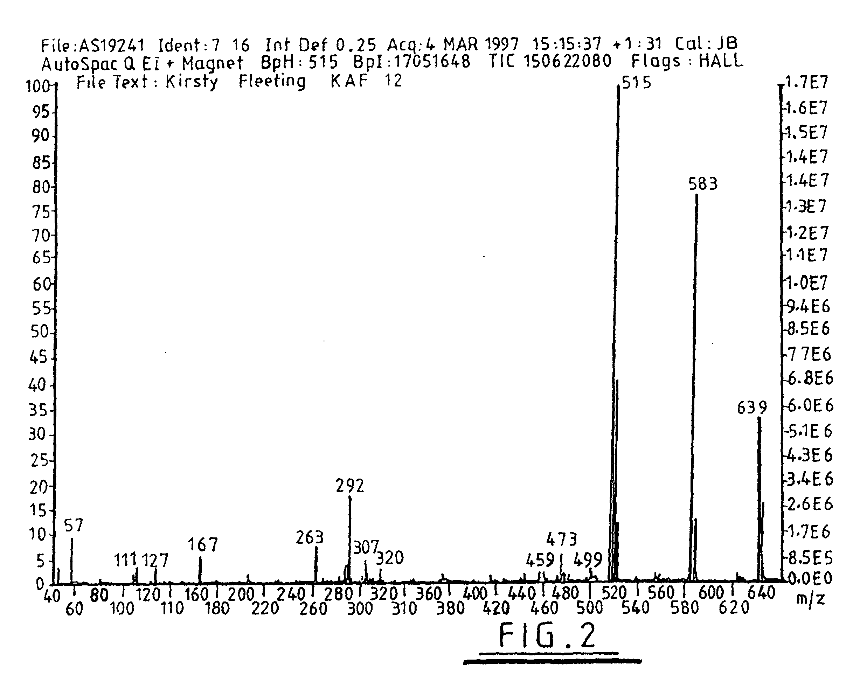

The resultant product was relatively air stable, very soluble in hexane and tetrahydrofuran, fairly soluble in ethanol and less in isopropanol. NMR and mass spectral analysis results for the product are shown in Figures 1 and 2 of the accompanying drawings respectively and the microanalysis results are as follows:

| Analysis | %C | %H |
|---|---|---|
| Calculated | 58.43 | 9.04 |
| Found | 56.86 | 8.30 |

These results indicate that the product had an approximate stoichiometry of Zr₂(OPrⁱ)₂thd₂.

### Example 2

### Preparation of zirconium di-tertiary-butoxy bis-tetramethylheptanedionate

72g of tetramethylheptanedione were dissolved with stirring in 1 litre of hexane in a 2 litre flask. 74g of zirconium tertiary butoxide were added to the flask (a slightly exothermic reaction) and the mixture brought to reflux for 1 hour. The flask was cooled and its contents filtered through a pad before being reduced in volume to 200ml using a Buchi roto-evaporator and set aside to crystallize. The resulting crystals were filtered off and dried in air or gently Buchi dried till the odour of hexane was removed.

The product was air stable, very soluble in hexane and tetrahydrofuran, fairly soluble in ethanol and less in isopropanol.

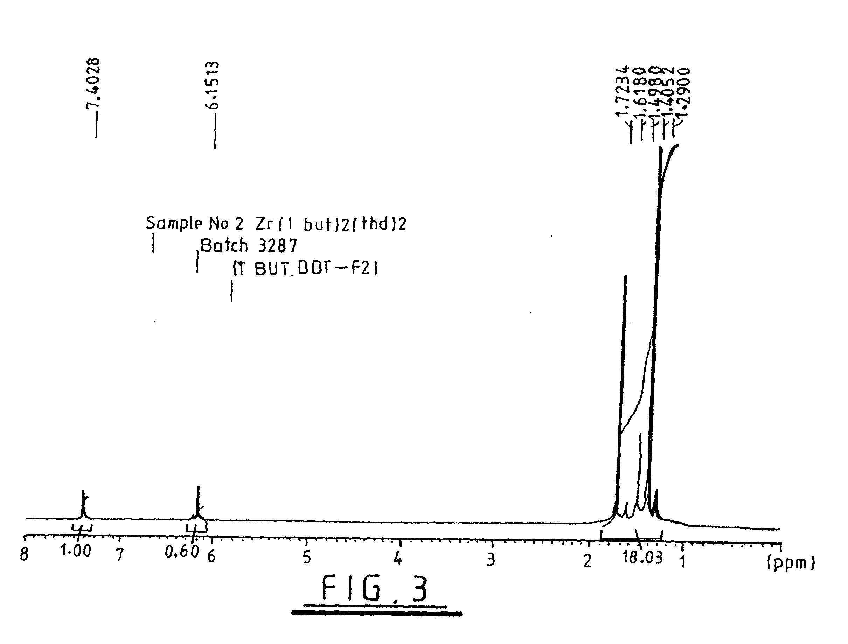

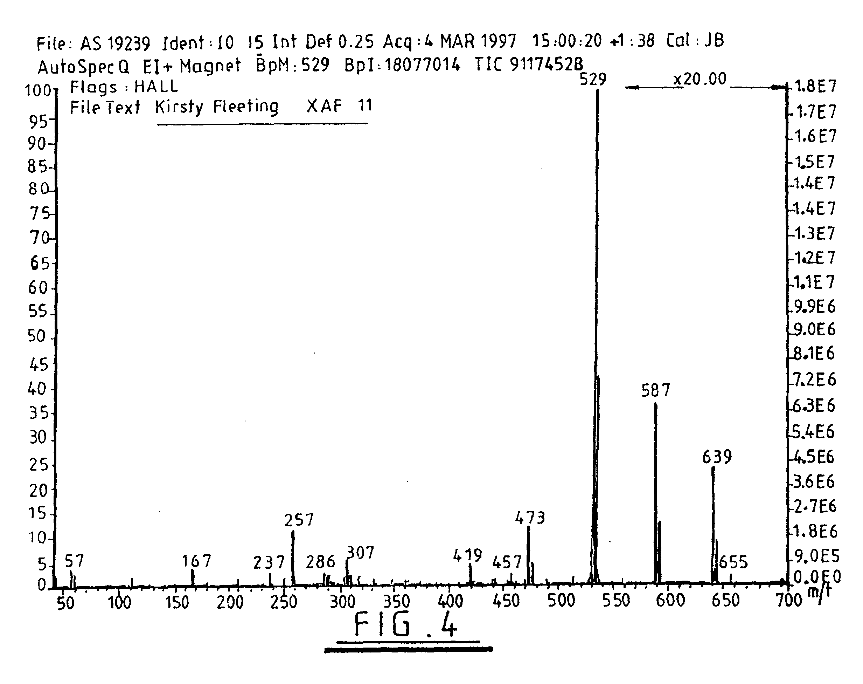

NMR and mass spectral analysis results for the product are shown in Figure 3 and 4 of the accompanying drawings respectively. The results of the elemental microanalysis are given below:

| Analysis | %C | %H |
|---|---|---|
| Calculated | 59.11 | 9.20 |
| Found | 58.66 | 8.70 |

These results indicate that the product had an approximate stoichiometry of Zr₂(OBu^{t})₂thd₂.

### Example 3

### Deposition of ZrO₂ thin films.

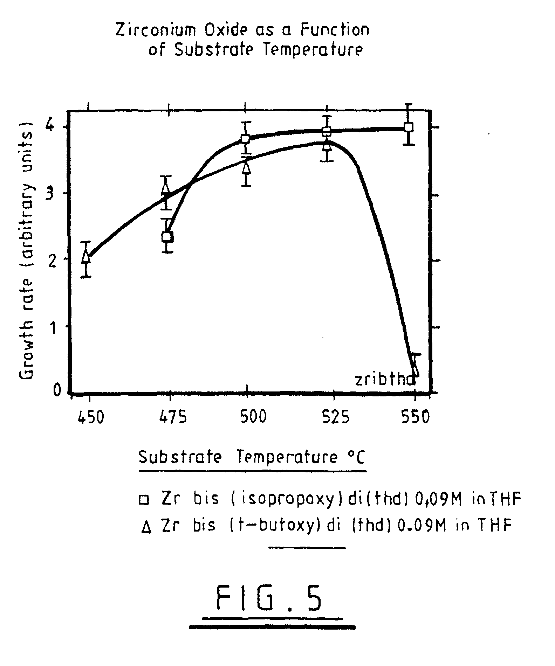

Thin films of ZrO₂ have been deposited by liquid injection MOCVD with both Zr(OPrⁱ)₂(thd)₂ and Zr(OBu^{t})₂(thd)₂ in concentrations of 0.09M in tetrahydrofuran. An evaporator temperature of 200°C was used with argon flow of 4 litres/min and oxygen flow of 100-300 sccm. Growth rates achieved at different substrate temperatures are shown in Figure 5 of the accompanying drawings.

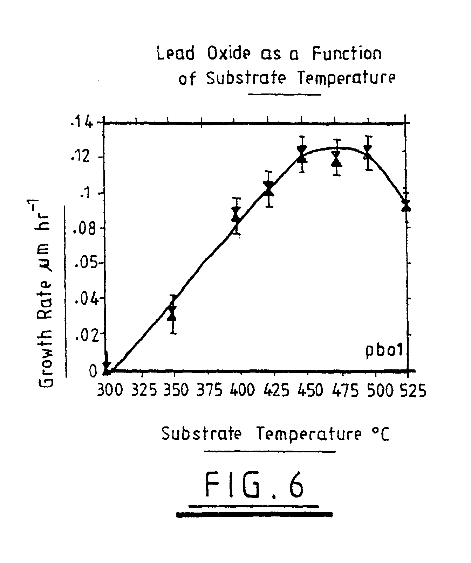

The suitability of either of these ZrO₂ precursors for use with a typical lead precursor, such as Pb(thd)₂ can be established from Figure 6 of the accompanying drawings which shows film lead oxide, including PbO₂ growth rates from this lead precursor at different substrate temperatures. As can be seen from Figures 5 and 6 both the Zr and Pb precursors provide optimum growth rates over a similar range of substrate temperatures, i.e. from about 450-525 °C.

It is believed that these Zr precursors are relatively stable to air and moisture due to having six-fold co-ordination around the Zr centre, in contrast to the coordinately unsaturated Zr(OR)₄ compounds.

### Example 4

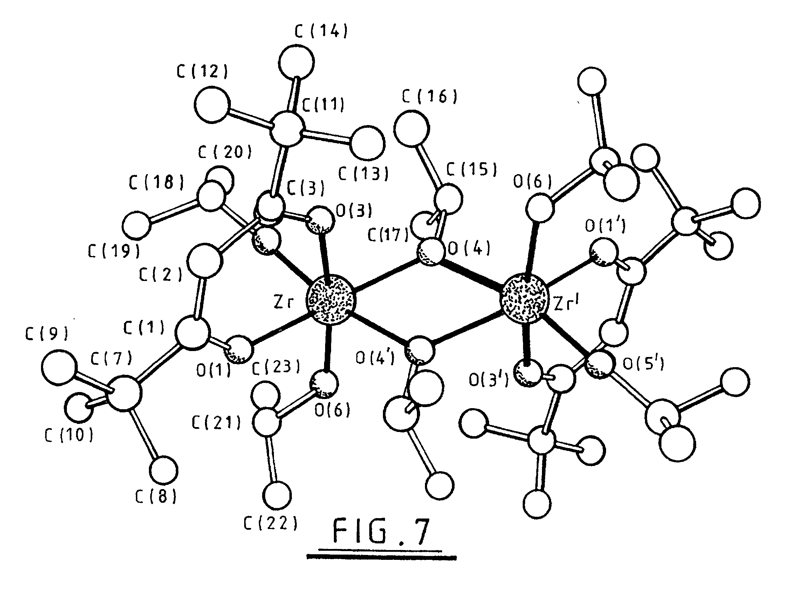

The product from Example 1 was recrystallized from n-hexane. The resultant product had the stoichiometry of Zr₂(OPrⁱ)₆(thd)₂ as shown in Figure 7 of the accompanying drawings.

### Example 5

### Synthesis of Zr₂(OPrⁱ)₆(thd)₂

Zirconium isopropoxide (2.93g, 7.56mmol) was dissolved in toluene (50cm³) and tetramethylheptanedionate (1.58cm³, 7.56mmol) was added. The solution was stirred at reflux for 1 hour after which time all volatiles were removed in vacuo to yield a cubite solid. The white solid was re-dissolved in toluene (20m³) and left to stand at 0° C overnight. Colourless crystals of Zr₂(OPrⁱ)₆(thd)₂ were filtered off.

### Example 6

### Synthesis of Zr₂(OPrⁱ)₆(thd)₂

Zirconium isopropoxide (2.97g, 7.25mmol) was dissolved in n-hexane (20ml) and tetramethylheptane - dionate (3.02cm³, 14.5mmol) was added. The solution was stirred at reflux for 1 hour after which time all volatiles were removed in vacuo to yield a white solid. This was re-dissolved in n-hexane (10cm³) and left to stand overnight. The crystallisation process was repeated four times to yield colourless rhombohedral cyrstals which gave the single ray crystal X-ray structure of Zr₂(OPrⁱ)₆(thd)₂. A proposed chemical structure for Zr₂(OPrⁱ)₆(thd)₂ is shown in Figure 7 of the accompanying drawings.

Zr₂(OPrⁱ)₆(thd)₂ is believed to be suitable for deposition of thin films of ZrO₂ by liquid injection MOCVD.

### Example 7

### Growth rates achieved using the precursor of Example 6.

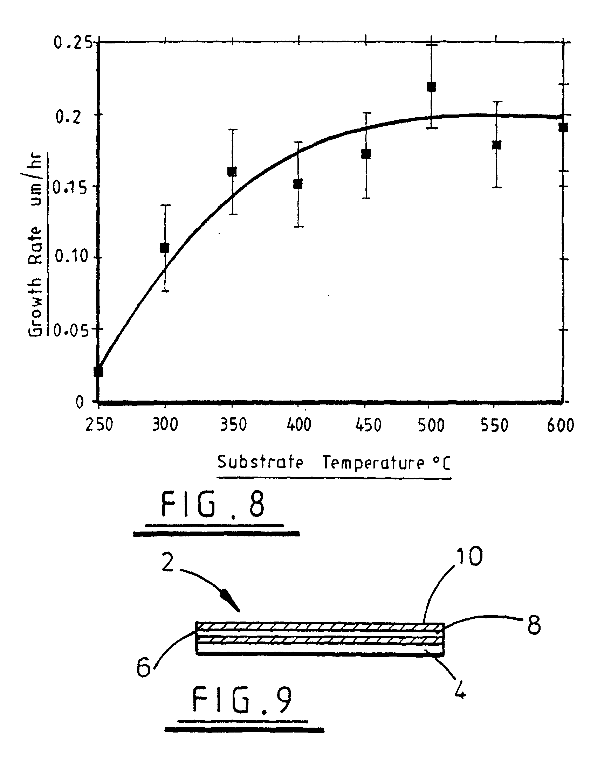

Zr₂(OPrⁱ)₆(thd)₂ has proved suitable for the deposition of thin films of ZrO₂ by liquid injection MOCVD. The films were grown using a 0.1 molar solution of Zr₂(OPrⁱ)₆(thd)₂ in tetrahydrofuran. An evaporator temperature of 200°C was used with a precursor injection rate of 3.5cm³hr⁻¹, an argon flow of 3000-5000 cm³ min ⁻¹ and an oxygen flow of 1000-2000cm³ min⁻¹. The growth rates achieved at different substrate temperatures are shown in Figure 8 of the accompanying drawings, and indicate that ZrO₂ growth occurs over a significantly wider temperature range than is achievable with other precursors such as Zr alkoxides or Zr(thd)₄.

It is believed that the novel Zr₂(OPr¹)₆(thd)₂ source is more suitable than existing Zr precursors for the MOCVD of Pb(Zr,Ti)O₃ and related ferro-electric materials at low substrate temperatures and of yttria-stabilised zirconia at more elevated temperatures.

The zirconium precursors according to the present invention may be used in the preparation of electro-ceramic device 2, as shown in Figure 9 of the accompanying drawings. A lower conducting electrode 6, such as platinum is deposited onto a substrate 4, such as silicon wafer or circuit and a film layer 8 of a zirconium oxide is formed thereon using the zirconium precursor of the present invention. An upper conducting electrode 10, which may also be platinum, is then deposited onto the zirconium oxide layer by appropriate deposition techniques. The electro-ceramic device may be used, for example, in ferro-electric memories or infra-red detectors, such as those used in security lights.

## Claims

1. A zirconium precursor suitable for use in MOCVD having the formula:
Zrₓ(OR)_{y}L_{z}
wherein
R is an alkyl group,
L is a β-diketonate group,
x = 1 or 2,
y = 2, 4 or 6, and
z = 1 or 2

2. A zirconium precursor as claimed in claim 1, wherein R is a branched chain alkyl group.

3. A zirconium precursor as claimed in claim 2, wherein R has less than 10 carbon atoms.

4. A zirconium precursor as claimed in claim 3, wherein R has 1 to 6 carbon atoms.

5. A zirconium precursor as claimed in claim 4, wherein R is selected from isopropyl and tertiary butyl groups.

6. A zirconium precursor as claimed in any one of claims 1 to 5, wherein the β-diketonate group L has the following formula: 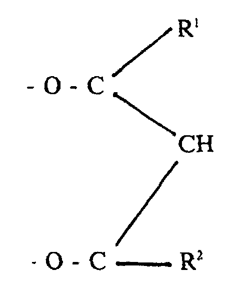 wherein R¹ and R² are the same or different and are selected from straight or branched, optionally substituted, alkyl groups and optionally substituted, phenyl groups.

7. A zirconium precursor as claimed in claim 6, wherein said optional substituents are selected from chlorine, fluorine and methoxy.

8. A zirconium precursor as claimed in any one of claims 1 to 7 having the formula
Zr(OR)₂L₂

9. The zirconium precursor Zr(OPrⁱ)₂(thd)₂, wherein thd is a tetramethylheptanedionate group.

10. The zirconium precursor Zr(OBu^{t})₂(thd)₂, wherein thd is a tetramethylheptanedionate group.

11. The zirconium precursor Zr₂(OPrⁱ)₆(thd)₂ wherein thd is a tetramethylheptanedionate.

12. A method of depositing thin films of or containing zirconium oxide using metalorganic precursors in an MOCVD technique, wherein the zirconium precursor is as claimed in any one of claims 1 to 11.

13. A method as claimed in claim 12, wherein one of the precursors is a lead precursor.

14. A method as claimed in claim 13, wherein the lead precursor is Pb(thd)₂.

15. A method as claimed in claim 12, wherein the substrate is selected from SiO₂,Si, SrTiO₃, MgO, Al₂O₃, Ge, Mo and W.

16. The use of a zirconium precursor as claimed in any one of claims 1 to 11 in the deposition of thin films of or containing zirconium oxide by an MOCVD technique.

17. A method of forming an electro-ceramic device comprising the steps of depositing a lower conducting electrode onto a substrate, depositing a film layer of or containing zirconium oxide onto said electrode and depositing an upper or further conducting electrode thereon wherein the layer of or containing zirconium oxide is formed from a zirconium precursor as claimed in any one of claims 1 to 11.

18. A method as claimed in claim 17, wherein the lower and/or upper conducting electrode is a metal.

19. A method as claimed in claim 18, wherein the metal is platinum.

20. A method as claimed in claim 17, 18 or 19, wherein the substrate is selected from a silicon wafer or circuit.

## Patentansprüche

1. Zirconiumvorläufer, der für eine Verwendung bei der MOCVD geeignet ist und die Formel
Zrₓ(OR)_{y}L_{z}
besitzt, worin
R eine Alkylgruppe,
L eine β-Diketonat-Gruppe,
x = 1 oder 2,
y= 2, 4 oder 6 und
z = 1 oder 2
bedeutet.

2. Zirconiumvorläufer nach Anspruch 1, wobei R eine verzweigte Alkylgruppe bedeutet.

3. Zirconiumvorläufer nach Anspruch 2, wobei R weniger als 10 Kohlenstoffatome enthält.

4. Zirconiumvorläufer nach Anspruch 3, wobei R 1 bis 6 Kohlenstoffatome enthält.

5. Zirconiumvorläufer nach Anspruch 4, wobei R unter der Isopropyl- und der *tert*.-Butylgruppe ausgewählt ist.

6. Zirconiumvorläufer nach einem der Ansprüche 1 bis 5, wobei die β-Diketonat-Gruppe L die Formel 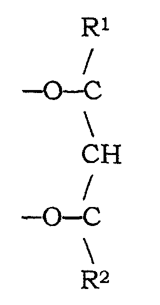 besitzt, worin R¹ und R² gegebenenfalls voneinander verschieden und unter geradkettigen oder verzweigten, wahlweise substituierten Alkylgruppen und wahlweise substituierten Phenylgruppen ausgewählt sind.

7. Zirconiumvorläufer nach Anspruch 6, wobei die optionalen Substituenten unter Chlor, Fluor und Methoxy ausgewählt sind.

8. Zirconiumvorläufer nach einem der Ansprüche 1 bis 7 mit der Formel Zr(OR)₂L₂.

9. Zirconiumvorläufer Zr(OPrⁱ)₂(thd)₂, wobei thd eine Tetramethylheptandionat-Gruppe bedeutet.

10. Zirconiumvorläufer Zr(Obu^{t})₂(thd)₂, wobei thd eine Tetramethylheptandionat-Gruppe bedeutet.

11. Zirconiumvorläufer Zr₂(OPrⁱ)₆(thd)₂, wobei thd ein Tetramethylheptandionat bedeutet.

12. Verfahren zum Abscheiden dünner Schichten, die aus Zirconiumoxid bestehen oder dieses enthalten, unter Verwendung metallorganischer Vorläufer in einem MOCVD-Verfahren, wobei der Zirconiumvorläufer wie in einem der Ansprüche 1 bis 11 definiert ist.

13. Verfahren nach Anspruch 12, wobei einer der Vorläufer ein Bleivorläufer ist.

14. Verfahren nach Anspruch 13, wobei der Bleivorläufer Pb(thd)₂ ist.

15. Verfahren nach Anspruch 12, wobei das Substrat unter SiO₂, Si, SrTiO₃, MgO, Al₂O₃, Ge, Mo und W ausgewählt ist.

16. Verwendung eines Zirconiumvorläufers nach einem der Ansprüche 1 bis 11 zum Abscheiden dünner Schichten, die aus Zirconiumoxid bestehen oder dieses enthalten, durch ein MOCVD-Verfahren.

17. Verfahren zur Herstellung einer elektrokeramischen Vorrichtung, das die Stufen Abscheiden einer unteren leitfähigen Elektrode auf ein Substrat, Abscheiden einer dünnen Schicht, die aus Zirconiumoxid besteht oder dieses enthält, auf diese Elektrode und Abscheiden einer oberen oder weiteren leitfähigen Elektrode darauf umfaßt, wobei die Schicht, die aus Zirconiumoxid besteht oder dieses enthält, aus einem Zirconiumvorläufer nach einem der Ansprüche 1 bis 11 gebildet wird.

18. Verfahren nach Anspruch 17, wobei die untere und/oder obere leitfähige Elektrode aus einem Metall besteht.

19. Verfahren nach Anspruch 18, wobei das Metall Platin ist.

20. Verfahren nach Anspruch 17, 18 oder 19, wobei das Substrat unter einem Siliciumwafer oder -schaltkreis ausgewählt ist.

## Revendications

1. Précurseur de zirconium adapté pour être utilisé dans une technique MOCVD ayant la formule suivante :
Zrₓ(OR)_{y}L_{z}
où
R est un groupe alkyle,
L est un groupe β-dicétonate,
x = 1 ou 2,
y = 2, 4 ou 6, et
z = 1 ou 2.

2. Précurseur de zirconium selon la revendication 1, dans lequel R est un groupe alkyle à chaîne ramifiée.

3. Précurseur de zirconium selon la revendication 2, dans lequel R a moins de 10 atomes de carbone.

4. Précurseur de zirconium selon la revendication 3, dans lequel R a 1 à 6 atomes de carbone.

5. Précurseur de zirconium selon la revendication 4, dans lequel R est sélectionné parmi des groupes isopropyle et butyle tertiaires.

6. Précurseur de zirconium selon l'une quelconque des revendications 1 à 5, où le groupe L β-dicétonate a la formule suivante : 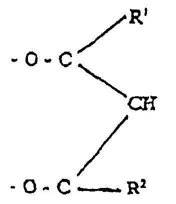 où R¹ et R² sont identiques ou différents et sont sélectionnés parmi des groupes alkyle, substitués de manière facultative, à chaîne linéaire ou ramifiée et des groupes phényle substitués de manière facultative.

7. Précurseur de zirconium selon la revendication 6, dans lequel lesdits substituants facultatifs sont sélectionnés parmi du chlore, du fluor et un groupe méthoxy.

8. Précurseur de zirconium selon l'une quelconque des revendications 1 à 7, ayant la formule suivante Zr(OR)₂L₂.

9. Précurseur de zirconium Zr(OPrⁱ)₂(thd)₂, dans lequel thd est un groupe tétraméthylheptanedionate.

10. Précurseur de zirconium Zr(OBuⁱ)₂(thd)₂, dans lequel thd est un groupe tétraméthylheptanedionate.

11. Précurseur de zirconium Zr₂(OPrⁱ)₆(thd)₂, dans lequel thd est un groupe tétraméthylheptanedionate.

12. Procédé de dépôt de films minces constitués ou contenant de l'oxyde de zirconium utilisant des précurseurs métalorganiques dans une technique MOCVD, dans lequel le précurseur de zirconium est un précurseur selon l'une quelconque des revendications 1 à 11.

13. Procédé selon la revendication 12, dans lequel un des précurseurs est un précurseur de plomb.

14. Procédé selon la revendication 13, dans lequel le précurseur de plomb est Pb(thd)₂.

15. Procédé selon la revendication 12, dans lequel le substrat est sélectionné parmi SiO₂, Si, SrTiO₃, MgO, Al₂O₃, Ge, Mo et W.

16. Utilisation d'un précurseur de zirconium selon l'une quelconque des revendications 1 à 11, dans le dépôt de films minces constitués ou contenant de l'oxyde de zirconium par une technique MOCVD.

17. Procédé de formation d'un dispositif électro-céramique comportant les étapes consistant à déposer une électrode conductrice inférieure sur un substrat, déposer une couche de film constituée ou contenant de l'oxyde de zirconium sur ladite électrode et déposer une électrode conductrice supérieure ou supplémentaire dessus, dans lequel la couche constituée ou contenant de l'oxyde de zirconium est formée à partir d'un précurseur de zirconium selon l'une quelconque des revendications 1 à 11.

18. Procédé selon la revendication 17, dans lequel l'électrode conductrice inférieure et/ou supérieure est un métal.

19. Procédé selon la revendication 18, dans lequel le métal est du platine.

20. Procédé selon la revendication 17, 18 ou 19, dans lequel le substrat est sélectionné parmi une plaquette ou un circuit de silicium.
